# EUROPEAN PATENT SPECIFICATION

(11) **EP 2 747 137 B1**
(45) Date of publication and mention of the grant of the patent: **25.09.2019**
(21) Application number: 13195866.2
(22) Date of filing: 05.12.2013
(51) Int. Cl.: H01L 23/049, H01L 23/495, H01L 23/498, H01L 21/48, H01L 25/07, H01L 23/433, H01L 23/00

(54) **Semiconductor module**
Halbleitermodul
Module semi-conducteur

(30) Priority: 19.12.2012 JP 2012277224
(43) Date of publication of application: 25.06.2014
(73) Proprietor: Fuji Electric Co., Ltd., Kawasaki-shi 210-9530 (JP)
(72) Inventor: Horie, Shunta, Kawasaki-shi, Kanagawa 210-9530 (JP)
(74) Representative: MERH-IP Matias Erny Reichl Hoffmann Patentanwälte PartG mbB

(56) References cited:
- EP-A2- 2 216 814
- DE-A1- 10 100 460

## Description

### CROSS-REFERENCE TO RELATED APPLICATION

This application is based on, and claims priority to, Japanese Patent Application No. 2012-277224, filed on December 19, 2012.

### BACKGROUND OF THE INVENTION

### 1. Field of the Invention

The present invention relates to a semiconductor module such as a power semiconductor module containing a plurality of semiconductor elements in a single package.

### 2. Description of the Related Art

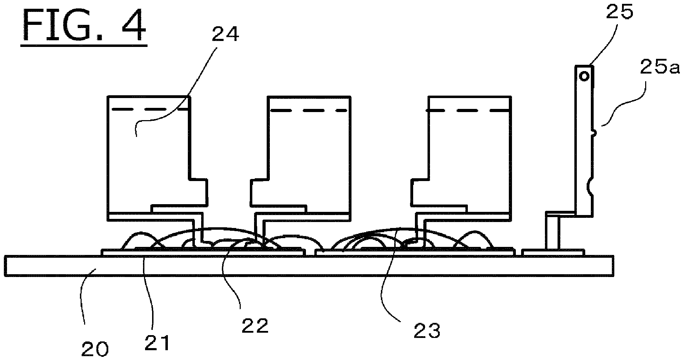

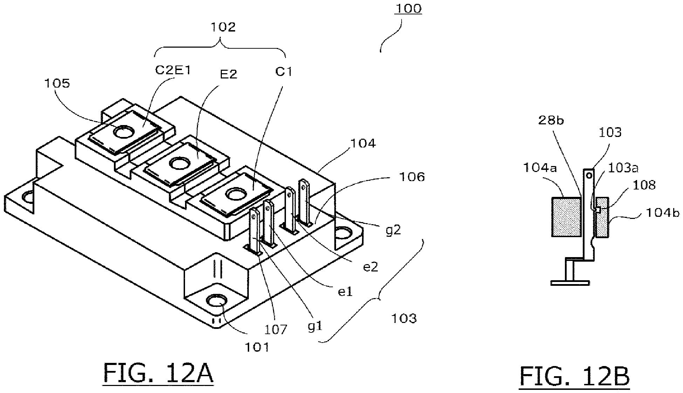

FIG. 12A is a perspective view of a known semiconductor module 100 for motor drive control containing a plurality of power semiconductor elements, for example, insulated gate bipolar transistors (IGBTs). This semiconductor module 100 comprises a metallic base plate 20, an insulated circuit board 21 on the base plate 20, and a plurality of power semiconductor elements 22 fixed at predetermined positions on the insulated circuit board 21 with solder as shown in FIG. 4. The semiconductor module 100 further comprises metallic main terminals 102, control terminals 103, and a plastic housing 104 that is a frame for protecting the power semiconductor elements 22 and for fixing the main terminals 102 and the control terminals 103 that are leading out of the housing. The space in the plastic housing 104 is filled with a resin composite in a gel state. The power semiconductor elements are mounted on a metallic circuit pattern formed on the insulated circuit board 21 and connected with aluminum wires 23 between the metallic circuit pattern and metallic electrodes on the semiconductor elements 22.

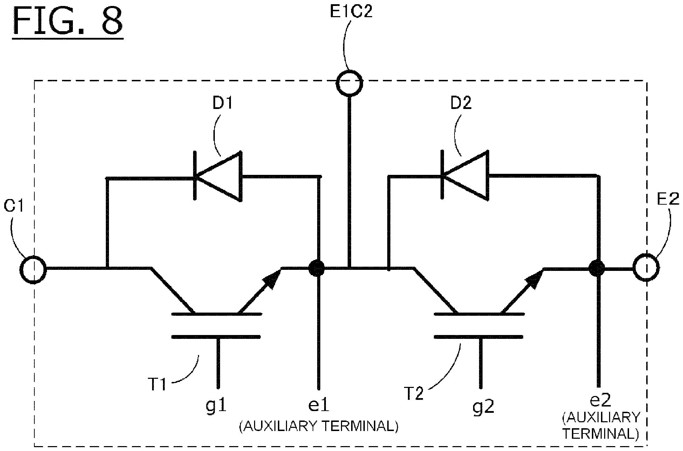

FIG. 8 shows an equivalent circuit of a semiconductor module composed of semiconductor elements of IGBTs T1 and T2 and free wheel diodes (FWDs) D1 and D2 anti-parallel-connected to the IGBTs T1 and T2, respectively. A resin composite in a gel state fills a space between the plastic housing 104 and a bottom plate that is the metallic base plate 20 for mounting these power semiconductor elements 22. The metallic main terminals 102, which are a C1 terminal, an E2 terminal, and a C1E2 terminal as shown in FIG. 12A, are connected externally through a screw holes 105 formed in the metallic main terminals 102 exposing to the center surface of the plastic housing 104. The auxiliary terminals 103, which are a g1 terminal, an e1 terminal, an e2 terminal, and a g2 terminal, are led out through the slits 106 formed in the end region of the surface of the plastic housing 104. The metallic base plate 20 has four holes for attaching itself to a heat sink at the corners of the base plate 20. The plastic housing 104 has an opening at the bottom thereof for the plastic housing 104 to be fitted to the base plate.

Patent Document 1 discloses a semiconductor device in which electrode terminals are ensured to be held on a thermoplastic resin housing to enhance reliability in assembling quality, and the electrode terminals are prevented from falling off from the resin housing due to vibration.

Patent Document 2 discloses a semiconductor module that includes a plastic housing, connection elements for external main connections and control connections, and an insulated substrate with a metallized surface. The insulated substrate mounting semiconductor elements is inserted into a bottom opening of the plastic housing.

Patent Document 3 discloses a semiconductor module with a high dielectric strength and high reliability in which a control terminal has a projection at a position of passing through the plastic housing and an L-shaped portion is provided in the control terminal in order to avoid transmission of stress onto the insulated circuit board in attaching and detaching processes of a connector.

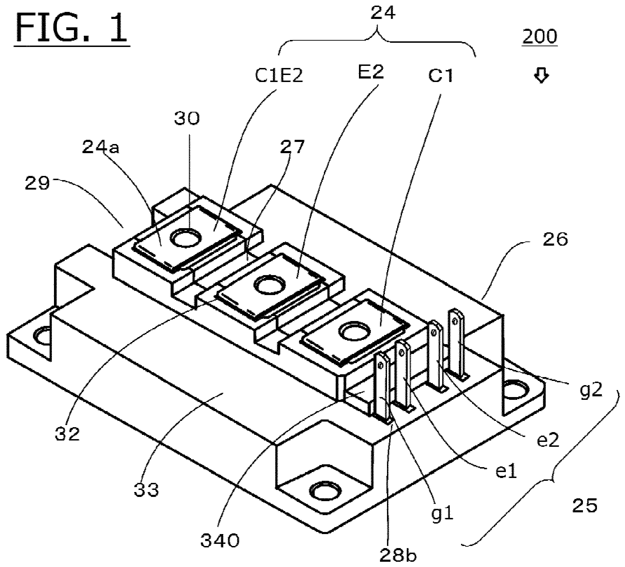

[Patent Document 1]
   Japanese Utility Model Application Publication No. H05-006852 (Abstract and FIG. 1, in particular)
[Patent Document 2]
   United States Patent No. 6,597,585 (Claim 1 and FIG. 3, in particular)
[Patent Document 3]
   WO2012/0066833 pamphlet (Abstract and FIG. 1, in particular)

DE 101 00 460 A1 describes a power semiconductor module having semiconductor tablets on a baseplate to which connection elements are fixed inside an electrically insulating housing. The connections are secured against movement in the direction of the baseplate. A power semiconductor module comprises semiconductor tablets on a baseplate to which connection elements are fixed inside an electrically insulating housing perpendicularly to the plane of the baseplate. The connections comprise buffer faces parallel to the baseplate which ensure, by the mounting of the module parallel to the baseplate, that the connections are secured against movement in the direction of the baseplate.

EP 2 216 814 A2 describes a power semiconductor device including a semiconductor element, a plastic housing, which covers the semiconductor element and has a plastic housing concave that is formed lower than the other part of the outer wall of the plastic housing, and a terminal, which is electrically connected to the semiconductor element within the plastic housing and extended from the plastic housing concave to the outside of the plastic housing. The position of the terminal within the plastic housing concave gives positional displacement information about the terminal.

In the semiconductor module 100 shown by the perspective view of FIG. 12A, the resin injected in the resin housing 104 is a resin composite in a gel state exhibiting flexibility that cannot rigidly fix the leading out terminals of the metallic main terminals 102 and the control terminals 103. Thus, the leading out terminals need to be fixed at the openings in the plastic housing 104 formed for leading out the terminals. Of the leading out terminals,
the metallic main terminals 102 are held with the resin housing 104 and thus, the stress exerted in the processes of external connection is scarcely transmitted to the bottom portion of the main terminal.

As for the auxiliary terminals 103, however, after fixing the auxiliary terminals 103 onto the insulated circuit board 21, the auxiliary terminals 103 need to be easily inserted through the openings 107 for the auxiliary terminals formed in the plastic housing 104 and also to be securely held on the housing. To meet these requirements, the openings 107 for the auxiliary terminals, as shown in FIG. 12A, each have a configuration of a slit with a size that is slightly larger than the cross-sectional size of the terminal. In addition, the auxiliary terminal 103 is provided with a projection and the plastic housing is provided with a notch to hold the terminal on the housing as shown in FIG. 12B. In FIG. 12B, the symbols 104a and 104 b designates partial cross-sections of the plastic housing. The auxiliary terminals 103 each have a projection 103a inside the plastic housing 104, and the plastic housing 104 has a recess 108 opposing the projection 103a. The recess 108 restricts vertical movement of the projection 103a. In the method of holding the terminals utilizing the projection and notch, however, the terminals are apt to become out of place in the longitudinal direction of the slit because the slit is formed with a little larger dimension. This is the case an external force is exerted toward the left at the upper position of the auxiliary terminal 103 in FIG. 12B. If the slit length is decreased to avoid disengagement of the auxiliary terminal, insertion can be hardly carried out, and some stress may be exerted on the bottom portion of the auxiliary terminals in the inserting process. Thus, the reduction of the slit length is restricted.

### SUMMARY OF THE INVENTION

The present invention has been made in view of the foregoing and an object of the present invention is to provide a semiconductor module that solves the above-mentioned problems and that allows easy engagement between the auxiliary terminals and the plastic housing in the assembling process and avoids transmission of stress onto the bottom portion of the auxiliary terminals or onto the insulated circuit board in the process of attaching an external connector. A method of manufacturing such a semiconductor module is also provided.

A semiconductor module according to a first aspect of the present invention comprises: a semiconductor element(s) mounted on an insulated circuit board adhered on a metallic base plate; a plastic housing to accommodate the semiconductor element; and a terminal(s) leading out vertically from an upper surface of the plastic housing; wherein the plastic housing is provided with an opening(s) for leading out the terminal(s) on the upper surface of the plastic housing; the terminal has a projection thereon at a position inside the plastic housing to restrict vertical movement of the terminal; the plastic housing is provided with a first recess that engages with the projection; the semiconductor module comprises a holding piece made of an insulating material having a cross-section of a triangle or a rectangle and one surface thereof being in contact with the terminal; the plastic housing is provided with a second recess on an upper surface thereof, the second recess receiving the holding piece so that the holding piece pushes the projection on the terminal toward the firsts recess.

A semiconductor module according to a second aspect of the present invention is the semiconductor module of the first aspect of the invention, wherein the holding piece has a tilting surface on a surface opposite to a surface that is in contact with the terminal, the tilting surface making the cross-section of the holding piece narrower in the lower position, and a surface of the plastic housing opposing the tilting surface of the holding piece has a tilting surface that fits to the tilting surface of the holding piece.

A semiconductor module according to a third aspect of the present invention is the semiconductor module of the first or second aspect of the invention, wherein the holding piece has a slot(s) at a position(s) corresponding to the terminal(s), which is inserted into the slot.

A semiconductor module according to a fourth aspect of the present invention is the semiconductor module of the any one of the first through third aspect of the invention, wherein the holding piece has projections or recesses on at least two surfaces thereof, and the plastic housing has recesses or projections that fit to the projections or recesses on the holding piece.

A semiconductor module according to a fifth aspect of the present invention is the semiconductor module of the any one of the first through fourth aspect of the invention, wherein the holding piece is adhered to the second recess on the plastic housing.

A sixth aspect of the present invention is a method of manufacturing a semiconductor module comprising steps of: fixing a semiconductor element(s) and a terminal(s) on an insulated circuit board adhered on a metallic base plate; and adhering a plastic housing that accommodates the semiconductor element(s) and leads out the terminal vertically from an opening provided on an upper surface of the plastic housing onto the metallic base plate; wherein after the terminal is led out from the openings using the plastic housing defined by claims 1 through 4, the holding piece defined by claims 1 through 4 is inserted into the second recess defined by claims 1 through 4 in such a way that the holding piece pushes the projection formed on the terminal toward the first recess on the plastic housing.

The present invention provides a semiconductor module and a method of manufacturing the same in which the plastic housing is easily engaged with the auxiliary terminals in the assembly process and stress transmission onto the bottom portion of the auxiliary terminals or onto the insulation circuit board is avoided in the process of attaching an external connector.

### BRIEF DESCRIPTION OF DRAWINGS

FIG. 1 is a perspective view of a semiconductor module according to Embodiment Example 1 of the present invention;
FIG. 2A is a perspective view of a holding piece in the semiconductor module according to Embodiment Example 1 of the invention;
FIG. 2b is a sectional view of an essential part of the semiconductor module according to Embodiment Example 1 of the invention;
FIG. 3 is a plan view of a semiconductor module with the plastic housing removed according to Embodiment Example 1 of the invention;
FIG. 4 is a front view of a semiconductor module with the plastic housing removed according to Embodiment Example 1 of the invention;
FIG. 5 is a side view, seen from the side of the auxiliary terminals, of a semiconductor module with plastic housing removed according to Embodiment Example 1 of the invention;
FIG. 6A is a plan view of the nut globe of the plastic housing of the semiconductor module according to Embodiment Example 1 of the invention;
FIG. 6B is a plan view of the plastic housing with the nut globe removed of the semiconductor module according to Embodiment Example 1 of the invention;
FIG. 7 is a plan view of the plastic housing with the nut globe engaged therewith of the semiconductor module according to Embodiment Example 1 of the invention;
FIG. 8 shows an equivalent circuit of the semiconductor module according to Embodiment Example 1 of the invention;
FIG. 9A is a sectional view of an essential part of a semiconductor module according to Embodiment Example 2 of the invention;
FIG. 9B is a perspective view of a holding piece according to Embodiment Example 2 of the invention;
FIG. 10 is a perspective view of a holding piece according to Embodiment Example 3 of the invention;
FIG. 11 is a perspective view of a holding piece according to Embodiment Example 4 of the invention;
FIG. 12A is a perspective view of a semiconductor module according to a conventional technology;
FIG. 12B is a sectional view of an essential part of the semiconductor module of FIG. 12A; and
FIG. 13 shows a relationship between a downward load [N] on an auxiliary terminal and a sunken stroke [mm] of the auxiliary terminal in a semiconductor module of the invention and in a conventional semiconductor module.

### DETAILED DESCRIPTION OF THE INVENTION

The following describes details of semiconductor modules according to some preferred embodiments of the present invention with reference to accompanying drawings. In the description and drawings of the embodiment examples below, the same constructions are given the same symbols and repeated description thereon is avoided. The drawings are not depicted with an accurate scale for better understanding. The present invention is not limited to the embodiment examples described below but various modifications are possible without departing from the scope of the invention.

### [Embodiment Example 1]

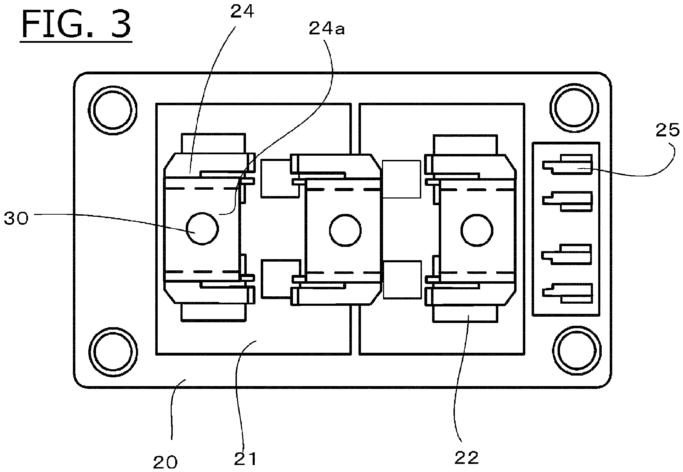

FIG. 1 is a perspective view of a semiconductor module according to Embodiment Example 1 of the invention. FIG. 3 is a plan view of the semiconductor module with a plastic housing removed, according to Embodiment Example 1 of the invention. FIG. 3, however, omits wiring with aluminum wire bonding, solder, and a metallic wiring pattern for the purpose of avoiding complexity of the drawing.

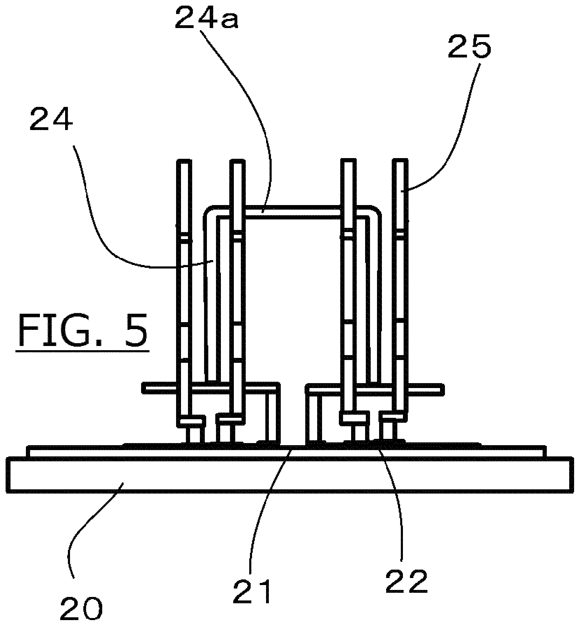

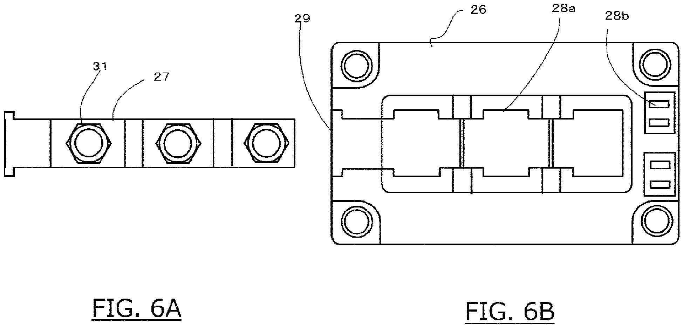

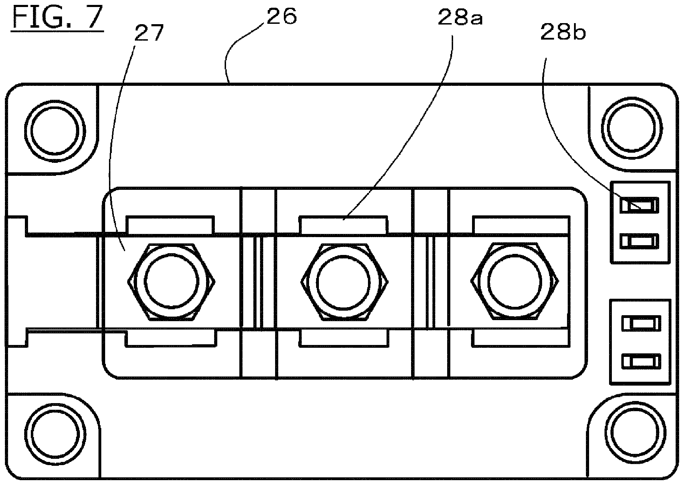

FIG. 4 is a front view of the semiconductor module with a plastic housing removed. FIG. 5 is a side view of the semiconductor module with a plastic housing removed seen from the side of auxiliary terminals, wherein aluminum wires are omitted in the drawing. FIG. 6B is a plan view of the plastic housing of the semiconductor module with a nut globe 27 removed from the plastic housing; and FIG. 6A is a plan view of the nut globe 27, which is a nut-receiving plastic body having nuts embedded at recessed places on the nut globe. FIG. 7 is a plan view of the semiconductor module with the nut globe 27 inserted from the side opposite to the auxiliary terminals and fitted to the plastic housing 26. FIG. 8 shows an equivalent circuit of the semiconductor module of the invention. A semiconductor module composed with the construction of the equivalent circuit of IFG. 8 is only an example of embodiment of the invention, and other circuit constructions should not be excluded.

This semiconductor module has semiconductor elements including IGBTs and free-wheeling diodes (FWDs) that construct the equivalent circuit of FIG. 8 mounted and soldered on a wiring pattern on an insulated circuit board and contained in the plastic housing.

The semiconductor module 200 of Embodiment Example 1 is described in detail below referring to FIGS. 1 through 5.

This semiconductor module 200 comprises a metallic base plate 20, an insulated circuit board 21 fixed on the metallic base plate 20, semiconductor elements 22 such as an IGBT and a FWD fixed at specified places on the insulated circuit board 21 with solder, terminals of main terminals 24 for main current and auxiliary terminals 25 including control terminals, and a plastic housing 26 having a bottom opening with dimensions to fit to a bottom plate of the metallic base plate 20.

The plastic housing 26 has a nut globe 27 that is inserted from an inserting hole 29 at the center-left side of the plastic housing 26 as shown in FIGS. 6 and 7. Inserting process is as follows. The plastic housing 26 is fitted onto the metallic base plate 20 having the semiconductor elements assembled thereon, and the leading out main terminals 24 of C1, E2, and C1E2 and the auxiliary terminals 25 of g1, e1, e2, and g2 are led out from the openings 28a and 28b for terminals provided on the surface of the plastic housing 26. Then, the nut globe 27 is inserted from the inserting hole 29 at the left side of the plastic housing 26. The positions of nut seat recesses 31 in the nut globe 27 are adjusted just beneath the attaching holes 30 for external terminals in the top parts 24a (FIGS. 3 and 5) of the lead-out main terminals 24 (hereinafter simply referred to as main terminals). In order to facilitate to insert the nut globe 27 from the inserting hole 29 at the side of the plastic housing 26, a step is formed on the center surface 32 (in FIG. 1) of the plastic housing 26, the center surface 32 being used for inserting the nut globe 27 and higher than the peripheral surface 33. The nut globe 27 has the nut seat recesses 31 at the positions corresponding to the attaching holes 30 for external terminals formed in the top part 24a of the main terminal 24, each nut seat recess 31 having an embedded nut. A screw of the external terminal is screwed into the nut to fasten the main terminal 24 with the screw and nut to connect the main terminal 24 to the external terminal. The present invention needs a construction having a step between the central surface 32 and the peripheral surface 33 of the plastic housing 26, the central surface 32 being higher than the peripheral surface 33 and the step being disposed at a certain distance from the auxiliary terminals. Nevertheless, the present invention does not have necessarily a construction that uses the nut globe (or a resin body for nut receiving).

The auxiliary terminals 25 are four terminals g1, e1, e2, and g2 and leading out from openings 28b of the plastic housing as shown in FIGS. 1 and 7. The auxiliary terminal 25 has a projection 25a that comes in contact with the side of the plastic housing 26 at the opening 28b for the auxiliary terminal when the auxiliary terminal 25 is inserted through the opening 28b. The projection 25a is shown in FIG. 4 and provided for the purpose of fixing the auxiliary terminal 25. A recess 40, which is a first recess, is formed in the plastic housing 26 at the side of the opening 28b to receive the projection 25a and to be engaged with the projection thereby rigidly fastening the auxiliary terminal 25.

If the auxiliary terminals 25 are appropriately fixed, even though a downward force is exerted on the auxiliary terminals 25 in the process of inserting a connector to the auxiliary terminals 25 to connect the auxiliary terminals 25 to external terminals (not shown in the figures), the exerted force is scarcely transmitted to the bottom part of the auxiliary terminals or the insulated circuit board below the auxiliary terminals inside the plastic housing 26. However, the openings 28b are formed with slightly larger dimensions than the cross-section of the auxiliary terminal in order to facilitate inserting the auxiliary terminals 25. As a result, when a certain force in the direction of longer side of the openings 28b is exerted on the auxiliary terminal 25, the fixing force on the auxiliary terminals with the projection 25a diminishes and the projection 25a does not properly carry out the function to block an external force. The loss of the function to block the external force would cause bending at the bottom portion of the auxiliary terminal 25 to lower the top position of the auxiliary terminal, which leads to poor external connection. The insulated circuit board may also be broken.

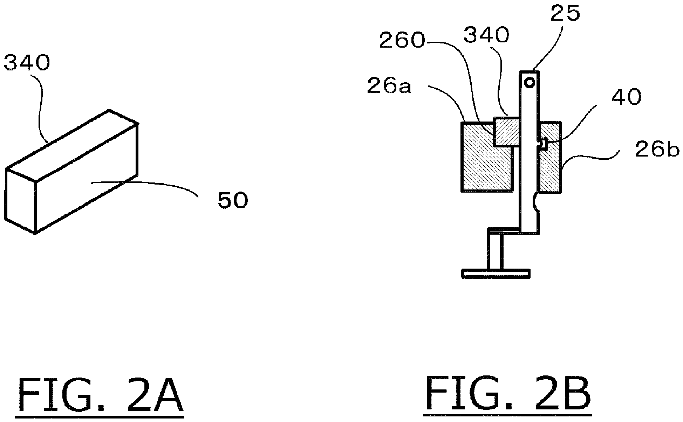

Accordingly, in an embodiment of the present invention, the step between the central surface 32 and the peripheral surface 33 of the plastic housing 26 is utilized, and a holding piece 340 is interposed between the step and the auxiliary terminals 25. Owing to this construction, the projection 25a properly performs the function to block an external force, preventing the auxiliary terminals 25 from being led into poor external connection and the insulated circuit board 21 from being broken. The holding piece 340 is made of an insulating material such as a resin. FIG. 2A is a perspective view of the holding piece 340 and FIG. 2B is a sectional view of an essential part including the holding piece 340 of a semiconductor module. As shown in FIGS. 2A and 2B, the holding piece 340 has a rectangular cross-section. One of the surfaces of the holding piece 340 is in contact with the auxiliary terminals 25. A second recess 260 is formed from the partial upper surface 26a of the plastic housing 26. The holding piece 340 is inserted into the second recess 260 so that the holding piece 340 pushes the projection 25a formed on the auxiliary terminal 25 against the first recess 40 in the plastic housing 26. This construction keeps the projection 25a engaged with the first recess 40 of the plastic housing 26 even when an external force acts on the auxiliary terminal 25 in the leftward direction in FIG. 2B. Thus, an external force acting on the auxiliary terminal 25 in the vertical direction does not generated large stress at the bottom part of the auxiliary terminal 25.

### [Embodiment Example 2]

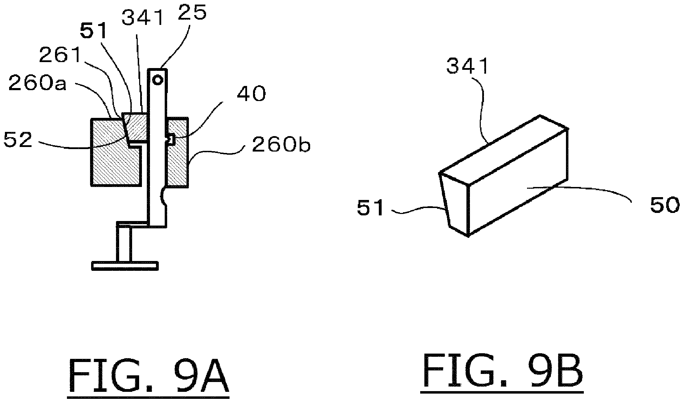

The following describes a second example of embodiment of the present invention, Embodiment Example 2. As shown in FIG. 9B, a holding piece 341 in Embodiment Example 2 has a surface 50 to become in contact with the auxiliary terminals 25 and another surface 51 opposite to the surface 50, the surface 51 being so tilting that the cross-section of the holding piece 341 becomes smaller in the lower position. The surface 52 of the plastic housing 26 opposing the tilted surface 51 is also tilted so as to fit to the surface 51 of the holding piece 341.

This construction allows the projection 25a pushed against the first recess 40 more strongly as the holding piece 341 is inserted into the second recess 261 in comparison with the construction of Embodiment Example 1. By setting an inserting depth of the holding piece 341 properly, a large dimensional tolerance is allowed in the width of the holding piece 341 and the width of the second recess 261 in the horizontal direction in FIG. 9A. This construction keeps more securely the projection 25a engaged with the first recess 40 of the plastic housing 26 even when an external force acts on the auxiliary terminals 25 in the leftward direction in FIG. 9A. Thus, an external force acting on the auxiliary terminal 25 in the vertical direction does not generate large stress at the bottom part of the auxiliary terminal 25. Therefore, the construction of Embodiment Example 2 eliminates poor external connection of the auxiliary terminals 25 and breakage of the insulated circuit board 21.

### [Embodiment Example 3]

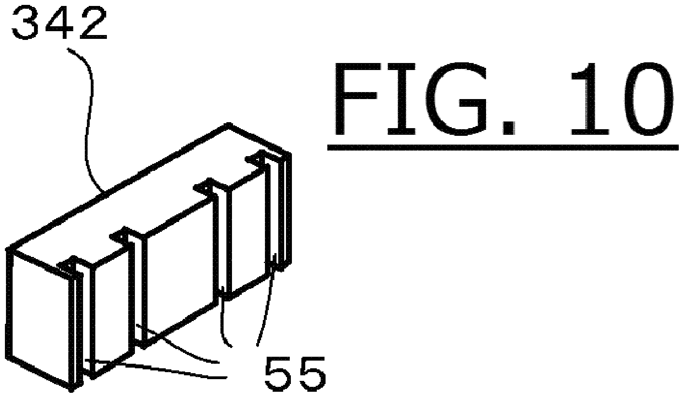

The following describes a third example of embodiment of the present invention, Embodiment Example 3. As shown in FIG. 10, a holding piece 342 in Embodiment Example 3 has slots 55 formed at the places corresponding to the respective auxiliary terminals 25 to fit to the terminals. This construction restricts movement of the auxiliary terminals 25 in the direction of the shorter side of the opening 28b for an auxiliary terminal due to an external force in the same direction. The slots 55 can be formed in the holding piece 341 of Embodiment Example 2 to obtain the same effects as in Embodiment Example 2.

### [Embodiment Example 4]

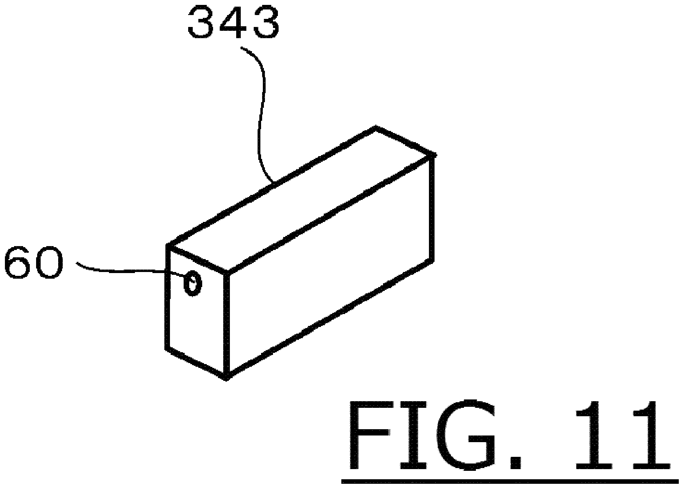

The following describes a fourth example of embodiment of the present invention, Embodiment Example 4. As shown in FIG. 11, a holding piece 343 in Embodiment Example 4 has third recesses 60 at least on two surfaces next to the surface in contact with the auxiliary terminals 25. The plastic housing 26 has projections corresponding to these third recesses 60. This construction securely fixes the holding piece 343, and is favorable because the construction fixes the auxiliary terminals 25 rigidly in the width direction i.e. shorter side direction of the terminals. The third recesses 60 and the projections formed on the plastic housing corresponding to the recesses 60 can be exchanged with each other, i.e., protrusions are formed on the holding piece 343 and recesses are formed on the plastic housing 26. In addition, the projection can have a configuration with a flat top surface and a tilted downward surface, the recess having a configuration to fit to such a projection. Moreover, this construction can be applied to Embodiment Examples 2 and 3.

### [Embodiment Example 5]

The following describes a fifth example of embodiment of the present invention, Embodiment Example 5. In Embodiment Example 5, the holding pieces 340, 341, 342, and 343 in Embodiment Examples 1 through 4 are adhered to the recessed parts formed in the plastic housing 26 corresponding to the holding pieces. Adhering the holding piece keeps securely the projection 25a engaged with the first recess 40 of the plastic housing 26 even when an external force acts on the auxiliary terminal 25 in the leftward direction in FIG. 2B, for example. Thus, an external force acting on the auxiliary terminal 25 in the vertical direction does not generate large stress at the bottom part of the auxiliary terminal 25.

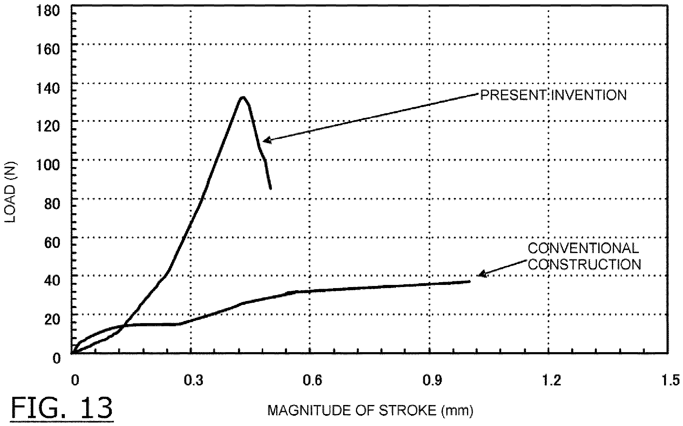

The inventor of the present invention has studied about relationship between a downward load [N] on an auxiliary terminal 25 and a sunken stroke [mm] of the auxiliary terminal 25 for cases of with and without a holding piece of the invention. Large sunken stroke of the auxiliary terminal 25 means poor performance to block stress generation by the projection 25a of the auxiliary terminal 25. FIG. 13 shows the measurement result.

FIG. 13 shows that the structure having a holding piece (340, 341, 342, 343) between the auxiliary terminal 25 and a part of the plastic housing according to the invention performs effective function to block stress generation by the projection 25a against a downward load on the auxiliary terminal 25 larger than 100 [N]; the sunken stroke of the auxiliary terminal 25 was only 0.4 [mm] with a load of 120 [N]. In contrast, a conventional construction without the holding piece, the load on the auxiliary terminal 25 was not able to increase to 40 [N] while the sunken stroke reached 1 [mm], indicating loss of the function to block stress generation by the projection 25a.

The holding pieces 340, 341, 342, and 343 can be made of the same material as of the plastic housing 26. An insulating resin material different from that of the plastic housing 26 can also be used. The material can be a ceramic plate. A length of the holding piece is sufficient with a dimension that allows fixing all auxiliary terminals 25.

Now, a method of manufacturing a semiconductor module according to the present invention will be described below. The insulated circuit board 21 is fixed on the metallic base plate 20; the semiconductor elements such as an IGBT and a FWD are fixed with solder at predetermined places on the insulated circuit board 21; and the main terminals 24 for main current and the auxiliary terminals 25 including control terminals are fixed at predetermined places. Then, the circuit components are assembled on the metallic base plate 20. With the base plate of assembled metallic base plate 20, the plastic housing 26 (or 260a and 260b in FIG. 9A) having the bottom opening is engaged. The main terminals 24 are exposed from the openings 28a for the main terminals provided on the higher flat surface 32 of the plastic housing 26 (or 260a and 260b); and the auxiliary terminals 25 are exposed from the openings 28b for the auxiliary terminals provided on the lower flat surface 33 of the plastic housing 26 (or 260a and 260b). Then, the nut globe 27, which is a nut-receiving resin body, is inserted from the inserting hole 29 formed at the side surface opposite to the side of the auxiliary terminals 25. After that, the holding piece 340 (or 341, 342, 343) is fitted between the higher flat surface 32 and the auxiliary terminals 25. Thus, the auxiliary terminals 25 are surely fixed in the longitudinal direction of the slit of the opening 28b for auxiliary terminal 25. Therefore, an external downward force exerted on the auxiliary terminals 25 during a connecting process of an external connector to the auxiliary terminals does never cause poor connection of external terminals and breakage of the insulated circuit board.

Features, components and specific details of the structures of the above-described embodiments may be exchanged or combined to form further embodiments optimized for the respective application. As far as those modifications are readily apparent for an expert skilled in the art they shall be disclosed implicitly by the above description without specifying explicitly every possible combination, for the sake of conciseness of the present description.

### [Description of Symbols]

- 20:: metallic base plate
- 21:: insulated circuit board
- 22:: semiconductor element
- 23:: aluminum wire
- 24:: main terminal
- 24a:: top part of the main terminal
- 25:: auxiliary terminal
- 25a:: projection
- 26:: plastic housing
- 27:: nut globe
- 28a:: opening for a main terminal
- 28b:: opening for an auxiliary terminal
- 29:: inserting hole
- 30:: attaching hole for an external terminal
- 31:: nut seat recess
- 32:: higher flat surface
- 33:: lower flat surface
- 340, 341, 342, 343:: holding piece
- C1:: collector terminal
- E2:: emitter terminal
- g1, g2:: gate terminal
- e1, e2:: emitter auxiliary terminal
- 100, 200:: semiconductor module

## Claims

1. A semiconductor module comprising:
at least one semiconductor element (22) mounted on an insulated circuit board (21) adhered on a metallic base plate (20);
a plastic housing (26) accommodating the semiconductor element (22); and
at least one terminal (25) leading out vertically from an upper surface (26a; 260a) of the plastic housing (26);
wherein
the plastic housing (26) is provided with an opening (28b) for leading out the terminal (25) on the upper surface (26a; 260a) of the plastic housing (26);
the terminal (25) has a projection (25a) thereon at a position inside the plastic housing (26) to restrict vertical movement of the terminal (25);
the plastic housing (26) is provided with a first recess (40) that engages with the projection (25a);
**characterized in that** the semiconductor module (100; 200) comprises a holding piece (340; 341; 342; 343) made of an insulating material and having a cross-section of a triangle or a rectangle and one surface (50) thereof being in contact with the terminal (25); and **in that**
the plastic housing (26) is provided with a second recess (260; 261) on an upper surface (26a; 260a) thereof, the second recess (260; 261) receiving the holding piece (340; 341; 342; 343) so that the holding piece (340; 341; 342; 343) pushes the projection (25a) on the terminal (25) toward the firsts recess (40).

2. The semiconductor module according to claim 1, wherein the holding piece (340; 341; 342; 343) has a tilting surface (51) on a surface opposite to a surface (50) that is in contact with the terminal (25), the tilting surface (51) making the cross-section of the holding piece (340; 341; 342; 343) narrower in the lower position, and a surface of the plastic housing (26) opposing the tilting surface (51) of the holding piece (340; 341; 342; 343) has a tilting surface (52) that fits to the tilting surface (51) of the holding piece (340; 341; 342; 343).

3. The semiconductor module according to claim 1 or claim 2, wherein the holding piece (340; 341; 342; 343) has at least one slot (55) at a position corresponding to the terminal (25), which is inserted into the slot (55).

4. The semiconductor module according to any one of claims 1 through 3, wherein the holding piece (340; 341; 342; 343) has projections (25a) or recesses (60) on at least two surfaces thereof, and the plastic housing (26) has recesses (40) or projections that fit to the projections (25a) or recesses (60) on the holding piece (340; 341; 342; 343).

5. The semiconductor module according to any one of claims 1 through 4, wherein the holding piece (340; 341; 342; 343) is adhered to the second recess (260; 261) on the plastic housing (26).

6. A method of manufacturing a semiconductor module comprising the steps of:
fixing at least one semiconductor element (22) and at least one terminal (25) on an insulated circuit board (21) adhered on a metallic base plate (20); and
adhering a plastic housing (26) that accommodates the semiconductor element (22) and leads out the terminal (25) vertically from an opening (28b) provided on an upper surface (26a; 260a) of the plastic housing (26) onto the metallic base plate (20), the plastic housing (26) being provided with a first recess (40) that engages with a projection (25a) on the terminal (25) at a position inside the plastic housing (26) to restrict vertical movement of the terminal (25); and **characterized in that**,
after the terminal (25) is led out from the openings (28b) using the plastic housing (26),
a holding piece (340; 341; 342; 343) made of an insulating material having a cross-section of a triangle or a rectangle and one surface (50) thereof being in contact with the terminal (25) is inserted into a second recess (260; 261) on an upper surface (26a; 260a) of the plastic housing (26), in such a way that the holding piece (340; 341; 342; 343) pushes the projection (25a) formed on the terminal (25) toward the first recess (40) on the plastic housing (26).

## Patentansprüche

1. Halbleitermodul, umfassend:
mindestens ein Halbleiterelement (22), das auf einer Isolierleiterplatte (21) befestigt ist, die auf einer metallischen Grundplatte (20) angehaftet ist;
ein Kunststoffgehäuse (26), welches das Halbleiterelement (22) aufnimmt; und
mindestens einen Anschluss (25), der vertikal aus einer oberen Fläche (26a; 260a) des Kunststoffgehäuses (26) herausführt;
wobei
das Kunststoffgehäuse (26) mit einer Öffnung (28b) zum Herausführen des Anschlusses (25) an der oberen Fläche (26a; 260a) des Kunststoffgehäuses (26) versehen ist;
der Anschluss (25) einen Vorsprung (25a) daran an einer Position innerhalb des Kunststoffgehäuses (26) aufweist, um eine vertikale Bewegung des Anschlusses (25) einzuschränken;
das Kunststoffgehäuse (26) mit einer ersten Aussparung (40) versehen ist, die in den Vorsprung (25a) eingreift;
**dadurch gekennzeichnet, dass**
das Halbleitermodul (100; 200) ein Haltestück (340; 341; 342; 343) umfasst, das aus einem Isoliermaterial hergestellt ist und einen Querschnitt eines Dreiecks oder eines Rechtecks aufweist, wobei eine Fläche (50) davon in Kontakt mit dem Anschluss (25) ist; und dadurch, dass
das Kunststoffgehäuse (26) mit einer zweiten Aussparung (260; 261) an einer oberen Fläche (26a; 260a) davon versehen ist, wobei die zweite Aussparung (260; 261) das Haltestück (340; 341; 342; 343) aufnimmt, sodass das Haltestück (340; 341; 342; 343) den Vorsprung (25a) an den Anschluss (25) in Richtung der ersten Aussparung (40) drückt.

2. Halbleitermodul nach Anspruch 1, wobei das Haltestück (340; 341; 342; 343) eine kippbare Fläche (51) auf einer Fläche gegenüber einer Fläche (50), die in Kontakt mit dem Anschluss (25) ist, aufweist und die kippbare Fläche (51) den Querschnitt des Haltestücks (340; 341; 342; 343) in der niedrigeren Position enger macht und eine Fläche des Kunststoffgehäuses (26) gegenüberliegend der kippbaren Fläche (51) des Haltestücks (340; 341; 342; 343) eine kippbare Fläche (52) aufweist, die zu der kippbaren Fläche (51) des Haltestücks (340; 341; 342; 343) passt.

3. Halbleitermodul nach Anspruch 1 oder Anspruch 2, wobei das Haltestück (340; 341; 342; 343) mindestens einen Schlitz (55) an einer Position aufweist, die dem Anschluss (25) entspricht, der in den Schlitz (55) eingeführt ist.

4. Halbleitermodul nach einem der Ansprüche 1 bis 3, wobei das Haltestück (340; 341; 342; 343) Vorsprünge (25a) oder Aussparungen (60) an mindestens zwei Flächen davon aufweist und das Kunststoffgehäuse (26) Aussparungen (40) oder Vorsprünge aufweist, die zu den Vorsprüngen (25a) oder Aussparungen (60) an dem Haltestück (340; 341; 342; 343) passen.

5. Halbleitermodul nach einem der Ansprüche 1 bis 4, wobei das Haltestück (340; 341; 342; 343) an der zweiten Aussparung (260; 261) an dem Kunststoffgehäuse (26) angehaftet ist.

6. Verfahren zum Herstellen eines Halbleitermoduls, wobei das Verfahren die Schritte umfasst:
Befestigen mindestens eines Halbleiterelements (22) und mindestens eines Anschlusses (25) an einer Isolierleiterplatte (21), die an einer metallischen Grundplatte (20) angehaftet ist; und
Anhaften eines Kunststoffgehäuses (26), welches das Halbleiterelement (22) aufnimmt und den Anschluss (25) vertikal von einer Öffnung (28b), die an einer oberen Fläche (26a; 260a) des Kunststoffgehäuses (26) vorgesehen ist, auf die metallische Grundplatte (20) herausführt, wobei das Kunststoffgehäuse (26) mit einer ersten Aussparung (40) versehen ist, die in einen Vorsprung (25a) an dem Anschluss (25) an einer Position innerhalb des Kunststoffgehäuses (26) eingreift, um eine vertikale Bewegung des Anschlusses (25) einzuschränken; und **dadurch gekennzeichnet, dass**,
nachdem der Anschluss (25) aus den Öffnungen (28b) unter Verwendung des Kunststoffgehäuses (26) herausgeführt ist,
ein Haltestück (340; 341; 342; 343), das aus einem Isoliermaterial hergestellt ist und einen Querschnitt eines Dreiecks oder eines Rechtecks aufweist, wobei eine Fläche (50) davon in Kontakt mit dem Anschluss (25) ist, in eine zweite Aussparung (260; 261) an einer oberen Fläche (26a; 260a) des Kunststoffgehäuses (26) derart eingeführt ist, dass das Haltestück (340; 341; 342; 343) den Vorsprung (25a), der an dem Anschluss (25) gebildet ist, in Richtung der ersten Aussparung (40) an dem Kunststoffgehäuse (26) drückt.

## Revendications

1. Module semi-conducteur comprenant :
au moins un élément semi-conducteur (22) monté sur une carte de circuit isolée (21) collée sur une plaque de base métallique (20) ;
un boîtier en plastique (26) hébergeant l'élément semi-conducteur (22) ; et
au moins une borne (25) sortant verticalement d'une surface supérieure (26a ; 260a) du boîtier en plastique (26) ;
dans lequel
le boîtier en plastique (26) est doté d'une ouverture (28b) pour faire sortir la borne (25) sur la surface supérieure (26a ; 260a) du boîtier en plastique (26) ;
la borne (25) a une saillie (25a) sur celle-ci dans une position à l'intérieur du boîtier en plastique (26) pour retreindre un mouvement vertical de la borne (25) ;
le boîtier en plastique (26) est doté d'un premier creux (40) qui se met en prise avec la saillie (25a) ;
**caractérisé en ce que**
le module semi-conducteur (100 ; 200) comprend une pièce de retenue (340 ; 341 ; 342 ; 343) constituée d'un matériau isolant et ayant une section transversale d'un triangle ou d'un rectangle et une surface (50) de celle-ci étant en contact avec la borne (25) ;
et **en ce que** le boîtier en plastique (26) est doté d'un deuxième creux (260 ; 261) sur une surface supérieure (26a ; 260a) de celui-ci, le deuxième creux (260 ; 261) recevant la pièce de retenue (340 ; 341 ; 342 ; 343) de sorte que la pièce de retenue (340 ; 341 ; 342 ; 343) pousse la saillie (25a) sur la borne (25) vers le premier creux (40).

2. Module semi-conducteur selon la revendication 1, dans lequel la pièce de retenue (340 ; 341 ; 342 ; 343) a une surface inclinée (51) sur une surface opposée à une surface (50) qui est en contact avec la borne (25), la surface inclinée (51) rendant la section transversale de la pièce de retenue (340 ; 341 ; 342 ; 343) plus étroite dans la position inférieure, et une surface du boîtier en plastique (26) opposée à la surface inclinée (51) de la pièce de retenue (340 ; 341 ; 342 ; 343) a une surface inclinée (52) qui s'adapte à la surface inclinée (51) de la pièce de retenue (340 ; 341 ; 342 ; 343).

3. Module semi-conducteur selon la revendication 1 ou la revendication 2, dans lequel la pièce de retenue (340 ; 341 ; 342 ; 343) a au moins une fente (55) dans une position correspondant à la borne (25), laquelle est insérée dans la fente (55).

4. Module semi-conducteur selon l'une quelconque des revendications 1 à 3, dans lequel la pièce de retenue (340 ; 341 ; 342 ; 343) a des saillies (25a) ou creux (60) sur au moins deux surfaces de celle-ci, et le boîtier en plastique (26) a des creux (40) ou des saillies qui s'adaptent au saillies (25a) ou creux (60) de la pièce de retenue (340 ; 341 ; 342 ; 343).

5. Module semi-conducteur selon l'une quelconque des revendications 1 à 4, dans lequel la pièce de retenue (340 ; 341 ; 342 ; 343) est collée sur le deuxième creux (260 ; 261) sur le boîtier en plastique (26).

6. Procédé de fabrication d'un module semi-conducteur comprenant les étapes suivantes :
la fixation d'au moins un élément semi-conducteur (22) et d'au moins une borne (25) sur une carte de circuit isolée (21) collée sur une plaque de base métallique (20) ; et
le collage d'un boîtier en plastique (26) qui héberge l'élément semi-conducteur (22) et fait sortir la borne (25) verticalement à partir d'une ouverture (28b) fournie sur une surface supérieure (26a ; 260a) du boîtier en plastique (26) sur la plaque de base métallique (20), le boîtier en plastique (26) étant doté d'un premier creux (40) qui se met en prise avec une saillie (25a) sur la borne (25) dans une position à l'intérieur du boîtier en plastique (26) pour restreindre un mouvement vertical de la borne (25) ; et **caractérisé en ce que**,
après avoir fait sortir la borne (25) par les ouvertures (28b) en utilisant le boîtier en plastique (26),
une pièce de retenue (340 ; 341 ; 342 ; 343) constituée d'un matériau isolant ayant une section transversale d'un triangle ou d'un rectangle et une surface (50) de celle-ci en contact avec la borne (25) est insérée dans un deuxième creux (260 ; 261) sur une surface supérieure (26a ; 260a) du boîtier en plastique (26) de manière à ce que la pièce de retenue (340 ; 341 ; 342 ; 343) pousse la saillie (25a) formée sur la borne (25) vers le premier creux (40) sur le boîtier en plastique (26).
